# EUROPÄISCHE PATENTSCHRIFT

(11) **EP 3 452 336 B1**
(45) Veröffentlichungstag und Bekanntmachung des Hinweises auf die Patenterteilung: **04.09.2019**
(21) Anmeldenummer: 17726925.5
(22) Anmeldetag: 29.05.2017
(51) Int. Cl.: B60R 16/03, H02H 3/20, B60R 16/023, G01R 31/02, H02H 3/14, H02H 5/10

(54) **MEHRSPANNUNGS-STEUERVORRICHTUNG FÜR EIN KRAFTFAHRZEUG, KRAFTFAHRZEUG UND BETRIEBSVERFAHREN FÜR DIE STEUERVORRICHTUNG**
MULTI-VOLTAGE CONTROL DEVICE FOR A MOTOR VEHICLE, MOTOR VEHICLE AND OPERATING METHOD FOR THE CONTROL DEVICE
DISPOSITIF DE COMMANDE MULTI-TENSION POUR VÉHICULE AUTOMOBILE, VÉHICULE AUTOMOBILE ET PROCÉDÉ DE FONCTIONNEMENT DU DISPOSITIF DE COMMANDE

(30) Priorität: 28.06.2016 DE 102016007900
(43) Veröffentlichungstag der Anmeldung: 13.03.2019
(73) Patentinhaber: Audi AG, 85045 Ingolstadt (DE)
(72) Erfinder: KAUSSLER, Richard, 85132 Schernfeld (DE)
(86) Internationale Anmeldenummer: PCT/EP2017/062899
(87) Internationale Veröffentlichungsnummer: WO 2018/001665

(56) Entgegenhaltungen:
- EP-A1- 1 453 171
- EP-A2- 1 067 647
- EP-A2- 1 241 768
- WO-A1-2005/013453
- WO-A1-2013/010694
- WO-A1-2013/050207
- WO-A1-2015/014551
- WO-A1-2015/071127
- WO-A2-01/45224
- WO-A2-2006/058824
- DE-A1- 19 929 305
- DE-A1-102014 017 571
- JP-A- 2004 203 091

## Beschreibung

Die Erfindung betrifft eine Steuervorrichtung für ein Kraftfahrzeug, die an zwei unterschiedliche Bordnetze des Kraftfahrzeugs angeschlossen wird. Die Steuervorrichtung kann zum Beispiel ein Steuergerät sein. Ein jeweiliger aus dem ersten und dem zweiten Bordnetz empfangener elektrischer Strom fließt über einen Masseanschluss in ein gemeinsames Massepotential des ersten und des zweiten Bordnetzes ab. Zu der Erfindung gehört auch ein Kraftfahrzeug mit den beiden Bordnetzen und der erfindungsgemäßen Steuervorrichtung. Schließlich gehört zu der Erfindung auch ein Verfahren zum Betreiben der Steuervorrichtung.

Eine Mehrspannungs-Versorgung für eine Steuervorrichtung kann zum Beispiel vorgesehen sein, wenn das Steuergerät auf der Grundlage einer ersten Versorgungsspannung einen elektrischen Verbraucher steuert, zum Beispiel eine elektrische Maschine, und eine interne Steuerschaltung der Steuervorrichtung selbst mit der niedrigeren zweiten Versorgungsspannung betrieben werden soll.

Bei Steuergeräten oder allgemein Steuervorrichtungen mit einer Mehrvolt-Versorgung, zum Beispiel einer 12 Volt- und einer 48 Volt-Versorgung, muss in der Regel eine Potentialtrennung der beiden Stromkreise erfolgen, die die Steuervorrichtung mit den beiden Bordnetzen bildet. Die Potentialtrennung hat auch eine getrennte Masseführung zu zwei getrennten Masseanschlüssen der Steuervorrichtung zur Folge. Das Massepotential des Kraftfahrzeugs wird dagegen oftmals von den beiden Bordnetzen gemeinsam genutzt.

Grund für die Potentialtrennung ist, dass bei einer Unterbrechung der elektrischen Verbindung zwischen den Masseanschlüssen der Steuervorrichtung einerseits und dem Massepotential andererseits sich insgesamt ein großer Stromkreis ergibt, der über das erste Bordnetz mit der größeren Versorgungsspannung (z.B. 48 Volt) über die Steuervorrichtung zu dem zweiten Bordnetz mit der kleineren Versorgungsspannung (z.B. 12 Volt) und erst von dort über das Massepotential zurück zum ersten Bordnetz führt. Ohne eine Potentialtrennung innerhalb der Steuervorrichtung würde es im zweiten Bordnetz (12 Volt) zu einer Rückspeisung der ersten Versorgungsspannung (48 Volt) kommen, durch welche die Spannung des ersten Bordnetzes mit umgekehrtem Vorzeichen, das heißt als negative Spannung, auf das zweite Bordnetz wirken würde. Bei einer Kombination aus einem ersten Bordnetz mit einer 48 Volt-Versorgungsspannung und einem zweiten Bordnetz mit einer 12 Volt-Versorgungsspannung kann es somit zu einem Spannungsabfall von -36 Volt über elektrischen Verbrauchern des zweiten Bordnetzes kommen. Diese Verbraucher sind aber oftmals aus Kostengründen nicht dagegen geschützt. Daher ist die heutzutage verwendete Lösung der Potentialtrennung mit zwei getrennten Masseanschluss für eine Steuervorrichtung die kostengünstigste und sicherste Lösung. Sie verhindert die Rückspeisung.

Eine Steuervorrichtung mit einer Mehrspannung-Versorgung ist zum Beispiel aus der WO 2005/013453 A1 bekannt. Diese Steuervorrichtung weist eine Schutzschaltung für den Fall auf, dass ein durch die Steuervorrichtung gesteuerter elektrischen Verbraucher einen Kurzschluss in einem der Bordnetze erzeugt.

Eine Steuervorrichtung zum Betrieb an mehreren Bordnetzen unterschiedlicher Versorgungsspannung ist auch aus der EP 1 453 171 A1 bekannt. Auch diese Steuervorrichtung weist eine elektronische Schutzschaltung zum Schutz gegen einen Kurzschluss in einem elektrischen Verbraucher auf, durch welchen ein Stromfluss durch die Steuervorrichtung einen Schwellenwert überschreiten könnte. Die Steuervorrichtung weist zwei getrennte Masseanschlüsse auf.

Aus der DE 199 29305 A1 ist ein Starthilfekabel mit integrierter Schalteinrichtung zum Unterbrechen eine Stromflusses auf der Grundlage von MOSFET-Schaltern bekannt.

DE 10 2014 017 571 A1 offenbart ein Kraftfahrzeug mit einer Steuervorrichtung für einen elektrischen Starter.

Der Erfindung liegt die Aufgabe zugrunde, in einer Steuervorrichtung einen Schutz für den Fall bereitzustellen, dass die Steuervorrichtung mit zwei unterschiedlich großen Versorgungsspannungen betrieben wird und es zu einer elektrischen Unterbrechung zwischen einem Masseanschlusses der Steuervorrichtung und einem Massepotential des Kraftfahrzeugs kommt.

Die Aufgabe wird durch die Gegenstände der unabhängigen Patentansprüche gelöst. Vorteilhafte Weiterbildungen der Erfindung sind durch die abhängigen Patentansprüche, die folgende Beschreibung sowie die Figuren beschrieben.

Durch die Erfindung ist eine Steuervorrichtung für ein Kraftfahrzeug bereitgestellt. Die Steuervorrichtung kann zum Beispiel ein Steuergerät sein. Die Steuervorrichtung weist zwei elektrische Anschlüsse zum Empfangen einer jeweiligen Versorgungsspannung auf. Ein erster elektrischer Anschluss ist zum Empfangen einer ersten Versorgungsspannung eines ersten elektrischen Bordnetzes des Kraftfahrzeugs eingerichtet. Bei der ersten Versorgungspannung kann es sich zum Beispiel um eine elektrische Gleichspannung in einem Bereich von 30 Volt bis 60 Volt, zum Beispiel 48 Volt, oder eine elektrische Hochspannung, das heißt eine elektrische Spannung größer als 60 Volt, handeln. Ein zweiter elektrischer Anschluss ist zum Empfangen einer zweiten Versorgungsspannung eines zweiten elektrischen Bordnetzes des Kraftfahrzeugs ausgelegt. Die zweite Versorgungsspannung ist kleiner als die erste Versorgungsspannung. Bei der zweiten Versorgungsspannung kann es sich zum Beispiel um eine elektrische Gleichspannung in einem Bereich von 10 Volt bis 50 Volt handeln, zum Beispiel eine 12 Volt-Spannung. Bei der Steuervorrichtung ist des Weiteren ein elektrischer Masseanschluss zum Anschließen eines gemeinsamen Massepotentials des ersten und des zweiten Bordnetzes bereitgestellt.

Als Schutz gegen die beschriebene Rückspeisung ist dem ersten Anschluss eine Schalteinrichtung nachgeschaltet, die ist dazu eingerichtet, in Abhängigkeit von einem Spannungssignal einen Stromfluss durch den ersten Anschluss zu unterbrechen oder zu blockieren. Das Spannungssignal ist ein solches Signal, das von einem Potentialunterschied zwischen dem zweiten Anschluss und dem Masseanschluss abhängig ist. Ändert sich also der Potentialunterschied zwischen dem zweiten Anschluss und dem Masseanschluss, so verändert sich auch das Spannungssignal. Erfüllt das Spannungssignal eine vorbestimmte Schaltbedingung, so wird der Stromfluss durch den ersten Anschluss von der Schalteinrichtung blockiert. Die Schalteinrichtung ist dabei derart eingerichtet, dass sie den Stromfluss unterbricht, falls das Spannungssignal eine Unterbrechung einer elektrischen Verbindung zwischen dem Masseanschluss und dem Massepotential indiziert. Welche Signalwerte das Spannungssignal in diesem Fall aufweisen kann, kann durch einfache Versuche festgestellt werden. Insbesondere ist vorgesehen, dass die Schalteinrichtung den Stromfluss unterbricht, falls der Potentialunterschied negativ ist, falls also (in Bezug auf das Massepotential) ein Potential des Masseanschlusses betragsmäßig größer als ein Potential des zweiten Anschlusses ist, wie dies zum Beispiel der Fall ist, wenn der Masseanschluss ein Potential aufweist, das dem Potential des ersten Anschlusses entspricht. Setzt man beispielsweise das Massepotential des Kraftfahrzeugs zu 0 Volt und die erste Versorgungsspannung und die zweite Versorgungsspannung als ein Massepotential größer 0, so ist der Potentialunterschied zwischen dem zweiten Anschluss und dem Masseanschluss positiv und beträgt den Wert der zweiten Versorgungsspannung. Bei Unterbrechung der elektrischen Verbindung zwischen Masseanschluss und Massepotential kann der Masseanschluss das Potential des ersten elektrischen Anschlusses aufweisen. Da die erste Versorgungspannung größer als die zweite Versorgungsspannung ist, ist somit der Potentialunterschied zwischen erstem Anschluss und Masseanschluss negativ.

Durch die Erfindung ergibt sich der Vorteil, dass keine Potentialtrennung innerhalb der Steuervorrichtung nötig ist und es dennoch bei der Unterbrechung der elektrischen Verbindung zwischen dem Masseanschluss der Steuervorrichtung und dem Massepotential des Kraftfahrzeugs nicht zu der beschriebenen Rückspeisung kommen kann, durch welche erste Versorgungsspannung des ersten Bordnetzes einen Einfluss auf elektrische Verbraucher des zweiten Bordnetzes hätte.

Zu der Erfindung gehören auch vorteilhafte Weiterbildungen, durch deren Merkmale sich zusätzliche Vorteile ergeben.

Mit diesem wirksamen Schutz ist deshalb bevorzugt auch vorgesehen, dass der Masseanschluss dazu vorgesehen ist, sowohl den Stromkreis des ersten als auch des zweiten Bordnetzes zu schließen. Insbesondere ist der Masseanschluss als ein einziger Masseanschluss vorgesehen. Mit anderen Worten sind die beiden elektrischen Bordnetze über ein vorrichtungsinternes Masseleitungselement der Steuervorrichtung elektrisch gekoppelt. Ein solches Masseleitungselement kann zum Beispiel eine Stromschiene oder ein elektrischer Draht oder eine Metallschicht einer Leiterplatine (PCB) sein. Somit entfällt die Notwendigkeit einer doppelten Verkabelung für zwei Masseanschlüsse.

Insbesondere ist vorgesehen, dass die besagte Schalteinrichtung zum Unterbrechen eines Stromflusses am ersten Anschluss derart in der Steuervorrichtung angeordnet ist, dass sie zwischen dem ersten Anschluss und einem Steuerausgang geschaltet ist. Bei dem Steuerausgang handelt es sich um einen elektrischen Anschluss, an welchen ein elektrisches Gerät des ersten Bordnetzes angeschlossen werden kann, z.B. eine elektrische Maschine. Über den Steuerausgang steuert die Steuervorrichtung dieses elektrische Gerät des ersten Bordnetzes. Mit anderen Worten ist der Steuerausgang durch die Steuervorrichtung gesteuert, das heißt eine an dem Steuerausgang bereitgestellte elektrische Spannung und/oder ein an dem Steuerausgang bereitgestellter elektrischer Strom wird durch die Steuervorrichtung gestellt. Indem nun die Schalteinrichtung zwischen den ersten Anschluss, über welchen die ersten Versorgungsspannung empfangen wird, und diesen Steuerausgang geschaltet ist, wird durch Schalten der Schalteinrichtung, sodass der Stromfluss unterbrochen ist, auch jedes an den Steuerausgang angeschlossen elektrische Gerät stromfrei oder stromlos geschaltet, unabhängig davon, ob das elektrische Gerät defekt ist oder nicht.

Bevorzugt ist vorgesehen, dass die Schalteinrichtung zum Unterbrechen des Stromflusses einen Transistor aufweist. Bevorzugt ist vorgesehen, dass als Transistor ein MOSFET (Metal Oxide Semiconductor Field Effect Transistor) bereitgestellt ist. Hierdurch ergibt sich der Vorteil, dass die Schalteinrichtung derart schnell schalten kann, das heißt den Stromfluss unterbrechen kann, dass eine Beschädigung elektrischer Verbraucher des zweiten Bordnetzes unwahrscheinlich ist. Insbesondere besteht trägt die Schaltdauer weniger als 100 Millisekunden, insbesondere weniger als 50 Millisekunden.

Die Schalteinrichtung wird durch das beschriebene Spannungssignal gesteuert oder in Abhängigkeit von den Spannungssignal geschaltet. Das Spannungssignal beschreibt den Potentialunterschied zwischen dem zweiten elektrischen Anschluss und dem Masseanschluss. Zum Erfassen dieses Spannungssignals weist die Steuerschaltung bevorzugt einen Steuertransistor auf. Dieser Transistor heißt Steuertransistor, weil es sich um einen anderen Transistor als dem beschriebenen Transistor zum Unterbrechen des Stromflusses selbst handeln soll. Der Steuertransistor ist derart verschaltet, dass zwischen dessen Gate- und Source-Anschluss das Spannungssignal abfällt. Damit wird der Steuertransistor direkt durch das Spannungssignal geschaltet oder gesteuert. Bei elektrischer Verbindung zwischen Masseanschluss und Massepotential ergibt sich dabei eine positive Gate-Source-Spannung und der Steuertransistor schaltet durch. Bei Unterbrechung der elektrischen Verbindung zwischen Masseanschluss und Massepotential ergibt sich eine negative Gate-Source-Spannung und damit sperrt der Steuertransistor. Dies kann unmittelbar genutzt werden, um das Gate des beschriebenen anderen Transistors zum Unterbrechen des Stromflusses selbst zu schalten oder zu steuern. Hierzu kann über die Drain-Source-Strecke des Steuertransistors das Gate des anderen Transistors mit dem Masseanschluss verschaltet sein.

Ein weiterer Vorteil eines Steuertransistors ist, dass die Schalteinrichtung unabhängig von dem Spannungssignal auch durch zumindest ein weiteres Schaltsignal einer anderen Signalquelle geschaltet werden kann. Mit anderen Worten sorgt der Steuertransistor für eine Entkopplung. So ist bevorzugt vorgesehen, dass die Schalteinrichtung dazu eingerichtet ist, aus zumindest einer weiteren Signalquelle ein jeweiliges Schaltsignal zu empfangen, um unabhängig von dem besagten Potentialunterschied die Schalteinrichtung ebenfalls zu schalten und zwar in Abhängigkeit von dem jeweiligen Schaltsignal. Das Schaltsignal wird hierzu über einen jeweiligen weiteren Steuertransistor empfangen. Somit kann die Schalteinrichtung auch zum Schalten des Stromflusses des über den ersten Anschluss empfangenen Versorgungsstroms auch im fehlerfreien Fall, also bei elektrischer Verbindung zwischen Masseanschluss und Massepotential genutzt werden.

Als eine Signalquelle ist gemäß einer Ausführungsform der Erfindung eine Testeinrichtung zum Schalten der Schalteinrichtung vorgesehen, die die Schalteinrichtung schaltet, falls eine vorbestimmte, von dem Potentialunterschied unabhängigen Testbedingung erfüllt ist. Die Testeinrichtung kann zum Beispiel als ein Programmodul eines Mikrocontrollers oder Mikroprozessors der Steuervorrichtung ausgestaltet sein. So kann als Testbedingung zum Beispiel ein Selbsttest der Steuervorrichtung vorgesehen sein, wie er beispielsweise bei einer Inbetriebnahme der Steuervorrichtung und/oder in vorbestimmten Zeitintervallen vorgesehen sein kann.

Als besonders vorteilhaft hat es sich erwiesen, wenn die Schalteinrichtung einen Kondensator aufweist, zwischen dessen Elektroden das Spannungssignal abfällt. Mit anderen Worten kann zum Beispiel an den beschriebenen Steuertransistor zwischen dessen Gate und Source der Kondensator geschaltet sein. Durch den Kondensator ergibt sich der Vorteil, dass sporadische Spannungsspitzen nicht zu einer unerwünschten Fehlauslösungen der Schalteinrichtung, das heißt einer unerwünschten, unnötigen Unterbrechung des Stromflusses am ersten Anschluss führen.

Wie bereits ausgeführt, umfasst die Erfindung auch ein Kraftfahrzeug, das ein erstes elektrisches Bordnetz zum Bereitstellen einer ersten Versorgungsspannung und ein zweites elektrisches Bordnetz zum Bereitstellen einer zweiten elektrischen Versorgungsspannung aufweist. Die zweite Versorgungsspannung ist dabei kleiner als die erste Versorgungsspannung. Des Weiteren ist ein Massepotential für beide Bordnetze bereitgestellt. Das Massepotential kann beispielsweise durch die Karosserie des Kraftfahrzeugs oder einen Rahmen des Kraftfahrzeugs gebildet sein. An das erste und das zweite Bordnetz und das Massepotential ist eine Ausführungsform der erfindungsgemäßen Steuervorrichtung angeschlossen. Durch die Steuervorrichtung wird in vorteilhafter Weise verhindert, dass bei einer Unterbrechung der elektrischen Verbindung zwischen dem Massepotential des Kraftfahrzeugs und dem Masseanschluss der Steuervorrichtung eine Rückspeisung der ersten Versorgungsspannung in das zweite Bordnetz stattfindet.

Das erfindungsgemäße Kraftfahrzeug ist bevorzugt als Kraftwagen, insbesondere als Personenkraftwagen oder Lastkraftwagen, ausgestaltet.

Schließlich gehört zu der Erfindung auch ein Verfahren zum Steuern einer Steuervorrichtung für ein Kraftfahrzeug. Das Verfahren geht davon aus, dass die Steuervorrichtung über einen ersten elektrischen Anschluss an eine erste Versorgungsspannung eines ersten elektrischen Bordnetzes und über einen zweiten elektrischen Anschluss eine zweite Versorgungsspannung eines zweiten elektrischen Bordnetzes empfängt. Wieder ist davon ausgegangen, dass die zweite Versorgungsspannung kleiner als die erste Versorgungsspannung ist. Gemäß dem Verfahren wird ein elektrischer Masseanschluss zum Anschließen eines gemeinsamen Massepotentials des ersten und des zweiten Bordnetzes bereitgestellt und eine dem ersten Anschluss nachgeschaltete Schalteinrichtung unterbricht oder blockiert in Abhängigkeit von dem beschriebenen Spannungssignal, dass ja von dem Potentialunterschied zwischen dem zweiten Anschluss und dem Masseanschluss abhängig ist, den Stromfluss durch den ersten Anschluss. In der beschriebenen Weise ist die Abhängigkeit von den Spannungssignal dabei derart gestaltet, dass die Schalteinrichtung den Stromfluss blockiert, falls das Spannungssignal eine Unterbrechung einer elektrischen Verbindung zwischen dem Masseanschluss der Steuervorrichtung und dem Massepotential des Kraftfahrzeugs indiziert.

Zu der Erfindung gehören auch Weiterbildungen des erfindungsgemäßen Verfahrens, die Merkmale aufweisen, wie sie bereits im Zusammenhang mit den Weiterbildungen der erfindungsgemäßen Steuervorrichtung beschrieben worden sind. Aus diesem Grund sind die entsprechenden Weiterbildungen des erfindungsgemäßen Verfahrens hier nicht noch einmal beschrieben.

Im Folgenden ist ein Ausführungsbeispiel der Erfindung beschrieben. Hierzu zeigt:
- Fig. 1: eine schematische Darstellung einer Ausführungsform des erfindungsgemäßen Kraftfahrzeugs und
- Fig. 2: eine schematische Darstellung einer Ausführungsform der erfindungsgemäßen Steuervorrichtung, wie sie in dem Kraftfahrzeug von Fig. 1 bereitgestellt sein kann.

Bei dem im Folgenden erläuterten Ausführungsbeispiel handelt es sich um eine bevorzugte Ausführungsform der Erfindung. Des Weiteren ist die beschriebene Ausführungsform auch durch weitere der bereits beschriebenen Merkmale der Erfindung ergänzbar.

In den Figuren sind funktionsgleiche Elemente jeweils mit denselben Bezugszeichen versehen.

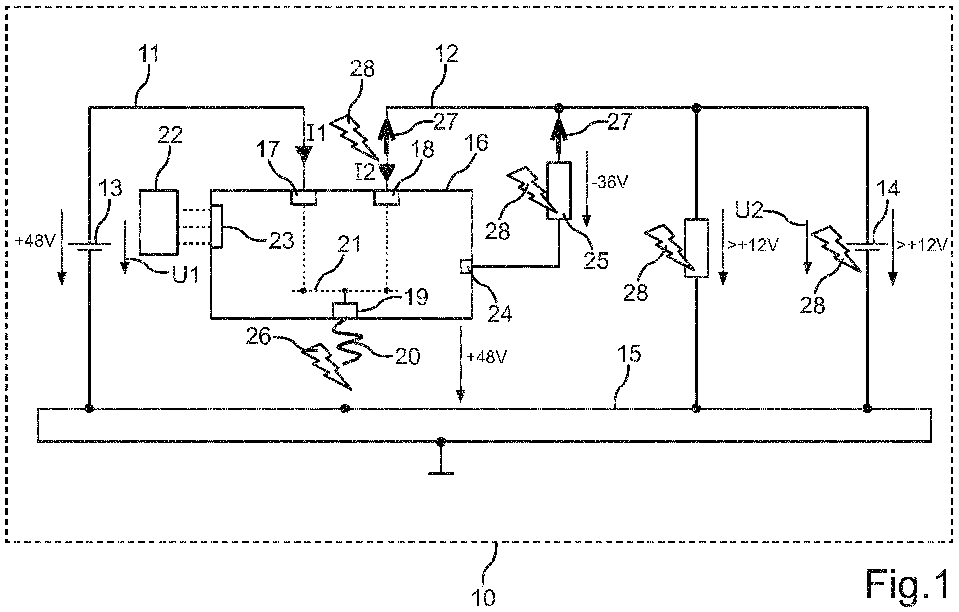

Fig. 1 zeigt ein Kraftfahrzeug 10, bei dem es sich zum Beispiel um einen Kraftwagen, insbesondere einen Personenkraftwagen, handeln kann. Das Kraftfahrzeug 10 kann ein erstes elektrisches Bordnetz 11 und ein zweites elektrisches Bordnetz 12 aufweisen. Eine erste Spannungsquelle 13 des ersten Bordnetzes 11 kann eine erste Versorgungsspannung U1 in dem ersten Bordnetz 11 erzeugen. Die erste Spannungsquelle 13 kann zum Beispiel einen Generator und/oder eine Batterie umfassen. Eine zweite Spannungsquelle 14 des zweiten Bordnetzes 12 kann eine zweite Versorgungsspannung U2 in dem zweiten Bordnetz 12 erzeugen. Die zweite Spannungsquelle 14 kann zum Beispiel einen Generator und/oder eine Batterie umfassen. Die zweite Versorgungspannung U2 ist kleiner als die erste Versorgungsspannung U1. In Fig. 1 ist der Veranschaulichung halber angenommen, dass die erste Versorgungspannung U1 = 48 Volt und die zweite Versorgungsspannung U2 = 12 Volt beträgt.

Für die beiden Bordnetze 11, 12 ist in dem Kraftfahrzeug 10 ein gemeinsames Massepotential 15 bereitgestellt, dass zum Beispiel auf der Grundlage einer Karosserie des Kraftfahrzeugs 10 gebildet sein kann. An die beiden Bordnetze 11, 12 kann eine Steuervorrichtung 16 angeschlossen sein, bei der sich zum Beispiel um ein Steuergerät handeln kann. Zum Anschließen an das erste Bordnetz 11 kann die Steuervorrichtung 16 einen ersten Anschluss 17, zum Anschließen an das zweite Bordnetz 12 einen zweiten Anschluss 18 aufweisen. Zum Anschließen der Steuervorrichtung 16 an das Massepotential 15 kann ein Masseanschluss 19 bereitgestellt sein, an welchen eine elektrische Verbindung 20 zum Verbinden mit dem Massepotential 15 angeschlossen sein kann. Die elektrische Verbindung 20 kann zum Beispiel durch einen Draht oder eine Schraube oder ein Litzenband gebildet sein. Innerhalb der Steuervorrichtung 16 kann über ein Masseleitungselement 21 ein aus dem ersten Bordnetz 11 empfangener Versorgungsstrom I1 und ein aus dem zweiten Bordnetz 12 empfangener Versorgungsstrom I2 jeweils zum Masseanschluss 19 geführt werden.

In Fig. 1 ist beispielhaft dargestellt, dass durch die Steuervorrichtung 16 ein erstes Gerät 22 an einem Steueranschluss 23 der Steuervorrichtung 16 angeschlossen sein kann und hierdurch über den Steueranschluss oder Steuerausgang 23 durch die Steuervorrichtung 16 geschaltet oder gesteuert werden kann. Beispielsweise kann es sich bei dem Gerät 22 um eine elektrische Maschine, zum Beispiel einen Elektromotor zum Unterstützen eines Verbrennungsmotors des Kraftfahrzeugs 10, handeln. Über einen zweiten Steueranschluss oder Steuerausgang 24 kann ein zweites Gerät 25 des zweiten Bordnetzes 12 durch die Steuervorrichtung 16 gesteuert werden.

Fig. 1 veranschaulicht einen Fehlerfall, bei welchem eine Unterbrechung 26 der elektrischen Verbindung 20 zwischen dem Masseanschluss 19 und dem Massepotential 15 zustande gekommen ist. Falls keine Schutzmaßnahme in der Steuervorrichtung 16 vorgesehen ist, kann über das Masseleitungselement 21 eine elektrische Verbindung zwischen dem ersten Anschluss 17 und dem zweiten Anschluss 18 bewirken, dass die erste Versorgungspannung U1 durch eine Rückspeisung 27 auf das zweite Bordnetz 12 wirkt. Hierdurch kann es zu einer Fehlerspannung 28 kommen, für die beispielhafte Werte (minus 36 Volt und größer als +12 Volt) in Fig. 1 für den eingangs beschriebenen Fall U1 = 48 Volt, U2 = 12 Volt angegeben sind.

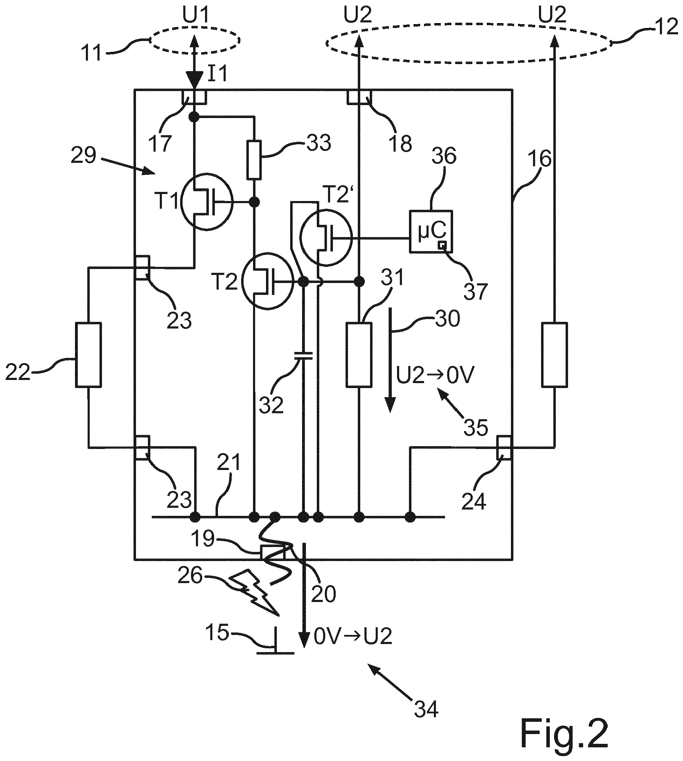

Bei der Steuervorrichtung 16 ist diese Rückspeisung 27 wirkungsvoll verhindert. Dies ist im Folgenden anhand von Fig. 2 erläutert.

Fig. 2 zeigt die Steuervorrichtung 16, in der eine Schalteinrichtung 29 bereitgestellt sein kann. Die Schalteinrichtung 29 kann zwischen den ersten Anschluss 17 und den Steuerausgang 23 geschaltet sein. Die Schalteinrichtung 29 kann einen Transistor T1 zum Schalten eines Stromflusses des Versorgungsstroms I1 aufweisen. Der Transistor T1 kann ein MOSFET sein. Der Transistor T1 ist insbesondere ein p-Kanal-MOSFET. Der erste Anschluss 17 und der Steuerausgang 23 können über eine Drain-Source-Strecke des Transistors T1 verschaltet sein. Eine Gate-Source-Spannung des Transistors T1 kann mittels eines Steuertransistor T2 geschaltet oder eingestellt oder gesteuert werden. Der Transistor T2 ist insbesondere ein n-Kanal-MOSFET. Der Transistor T2 muss lediglich ein Kleinsignaltransistor sein, das heißt er muss nicht in der Lage sein, die erste Versorgungsspannung U1 selbst schalten oder blockieren zu können.

In Fig. 2 sind zusätzliche elektrische Bauteile, wie sie zur Arbeitspunkteinstellung, Robustheitsmaßnahmen und Schutzbeschaltung der Transistoren in an sich bekannter Weise eingesetzt werden, nicht dargestellt.

Der Steuertransistor T2 kann das Gate des Transistors T1 über die Drain-Source-Strecke des Steuertransistor T2 mit dem Masseanschluss 19 verbinden. Ein Gate des Steuertransistors T2 kann mit dem zweiten elektrischen Anschluss 18 gekoppelt oder verschaltet sein. Hierdurch fällt als Gate-Source-Spannung des Steuertransistors T2 ein Spannungssignal 30 ab, das von dem Potentialunterschied zwischen dem zweiten Anschluss 18 und dem Masseanschluss 19 abhängig ist. Es kann ein Messwiderstand 31 zum Abgreifen des Spannungssignals 30 vorgesehen sein. Über einen Kondensator 32 kann das Spannungssignal 30 von Spannungsspitzen befreit werden, um eine Fehlauslösung der Schalteinrichtung 29 zu verhindern.

Im elektrisch leitfähigen Zustand des Steuertransistors T2 ist das Gate des Transistors T1 mit dem Masseanschluss 19 derart elektrisch verbunden, dass der Transistor T1 elektrisch leitend geschaltet ist. Wird der Steuertransistor T2 in den elektrisch sperrenden Zustand geschaltet, so wird über einen Pullup-Widerstand 33 das Potential des Gates des Transistor T1 auf das Potential des ersten Anschlusses 17 angehoben. Hierdurch schließt der Transistor T1, das heißt er wird in den elektrisch sperrenden Zustand geschaltet. Dies unterbricht den Stromfluss des Versorgungsstromes I1.

Falls es nun zu der Unterbrechung 26 der elektrischen Verbindung 20 kommt, so findet ein Spannungsübergang am Masse Anschluss 19 statt, der von 0 Volt (Massepotential) zur Versorgungsspannung U2 führt. Entsprechend ergibt sich ein Spannungswechsel 35 für das Spannungssignal 30 von der zweiten Versorgungspannung U2 hin zu 0 Volt. Damit wird der Steuertransistor T2 in der beschriebenen Weise von dem elektrisch leitenden Zustand in den elektrisch sperrenden Zustand geschaltet und der Stromfluss des Versorgungsstroms I1 wird durch den Transistor T1 in der beschriebenen Weise unterbrochen. Damit ist es verhindert, dass über das Masseleitungselement 21 die beschriebene Rückspeisung 27 vom ersten Bordnetz 11 ins zweite Bordnetz 12 stattfindet. Durch Verwendung der isolierten Gates des Transistors T1 und des Transistors T2 kann auch über die Schalteinrichtung 29 die Rückspeisung 27 nicht stattfinden.

Für erhöhte Sicherheitsanforderungen kann die Schaltung auch redundant aufgebaut werden.

Zu Testzwecken, das heißt zu einer Testauslösung oder Testunterbrechung, kann ein weiterer Steuertransistor T2' ebenfalls mit dem Gate des Transistors T2 elektrisch verbunden sein. Hierdurch kann beispielsweise durch einen Mikrocontroller 36 die Schalteinrichtung 29 ebenfalls gesteuert werden, um den Transistor T1 elektrisch sperrend zu schalten. So kann der Mikrocontroller über 36 die Transistoren T2' und T2 den Transistor T1 sperren und die Versorgung am Anschluss 17 testweise unterbrechen. Der Mikrocontroller 36 kann zum Beispiel eine Testeinrichtung 37 aufweisen, zum Beispiel ein Programmodul, um einen Funktionstest der Schalteinrichtung 29 durchzuführen. Der Mikrocontroller 36 mit der Testeinrichtung 37 stellt somit eine Signalquelle zum Erzeugen eine Schaltsignals für die Schalteinrichtung 29 dar. Elektrotechnisch müsste in der Zuleitung zum Gate des Transistors T2 vor dem Anschluss des Transistors T2' ein Widerstand eingezeichnet werden um den Transistor T2' im Falle eines Tests vor zu hohen Strömen zu schützen. Allerdings sind in Fig. 2, wie in den anderen Fälle auch, die meisten Hilfsbauteile zur Arbeitspunkteinstellung und zum Bauteilschutz nicht dargestellt.

Die hier aufgezeigte Schaltung gibt somit die 48 Volt-Versorgung (U1-Versorgung) nur frei, solange eine positive Spannung zwischen dem internen Massepotential und der 12 Volt-Versorgung (U2-Versorgung) vorhanden ist. So wird sichergestellt, dass bei der Masseunterbrechung oder kurz Unterbrechung 26 die 48 Volt-Versorgung nicht schädigend auf die restlichen Komponenten einwirken kann. Die Schaltung zeichnet sich durch ihren geringen Bauteilbedarf aus. Außerdem benötigt sie zum Abschalten keine elektrische Versorgung und ist somit eigensicher. Die Schaltung kann mit allen Endstufentypen eingesetzt werden. Im Steuergerät dürfen sich 12 Volt-Highside-Treiber, 12 Volt-Lowside-Treiber, 48 Volt-Highside-Treiber und 48 Volt-Lowside-Treiber befinden. Ein solcher Treiber kann zum Beispiel durch eine Halbbrücke und/oder eine B6-Brücke gebildet sein. Ebenso dürfen alle Arten von Freilaufdioden integriert sein.

Da sich mit der Schaltungseinrichtung 29 das Potential des Steuergeräts maximal auf Spannungen anheben kann, die bereits aus reinen 12 Volt-Systemen bekannt sind und erprobt sind, benötigt das Steuergerät keine zusätzlichen Sicherungsmaßnahmen. Es wird keine Potentialtrennung und/oder keine getrennte Masseführung benötigt. Die Schaltung besticht somit durch ihren geringen notwendigen Aufwand.

Insgesamt zeigt das Beispiel, wie durch die Erfindung eine Sicherheitsabschaltung für 12V/48V-Steuergeräte bei Masseunterbrechungen bereitgestellt werden kann.

## Patentansprüche

1. Steuervorrichtung (16) für ein Kraftfahrzeug (10), aufweisend
- einen ersten elektrischen Anschluss (17) zum Empfangen einer ersten Versorgungsspannung (U1) einer ersten Spannungsquelle (13) eines ersten elektrischen Bordnetzes (11) des Kraftfahrzeugs (10) und
- einen zweiten elektrischen Anschluss (18) zum Empfangen einer zweiten Versorgungsspannung (U2) einer zweiten Spannungsquelle (14) eines zweiten elektrischen Bordnetzes (12) des Kraftfahrzeugs (10), wobei die zweite Versorgungsspannung (U2) kleiner als die erste Versorgungspannung (U1) ist,
wobei ein elektrischer Masseanschluss (19) zum Anschließen eines gemeinsamen Massepotentials (15) des ersten und des zweiten Bordnetzes (11, 12) bereitgestellt ist, wobei der Masseanschluss (19) dazu vorgesehen ist, sowohl einen Stromkreis des ersten Bordnetzes (11) als auch des zweiten Bordnetzes (12) zu schließen, und eine dem ersten Anschluss (17) nachgeschaltete Schalteinrichtung (29) dazu eingerichtet ist, in Abhängigkeit von einem Spannungssignal (30), das von einem Potentialunterschied zwischen dem zweiten Anschluss (18) und dem Masseanschluss (19) abhängig ist, einen Stromfluss durch den ersten Anschluss (17) zu blockieren, wobei die Schalteinrichtung (29) den Stromfluss blockiert, um eine elektrische Verbindung über ein Masseleitungselement (21) zwischen dem ersten elektrischen Anschluss (17) und dem zweiten elektrischen Anschluss (18) und eine dadurch bewirkte Rückspeisung (27) der ersten Versorgungsspannung (U1) auf das zweite elektrische Bordnetz (12) zu verhindern, falls das Spannungssignal (30) eine Unterbrechung (26) einer elektrischen Verbindung (20) zwischen dem Masseanschluss (29) und dem Massepotential (15) indiziert.

2. Steuervorrichtung (16) nach Anspruch 1, wobei die Schalteinrichtung (29) zwischen den ersten Anschluss (17) und einen von der Steuervorrichtung (16) gesteuerten Steuerausgang (23) zum Steuern eines elektrischen Geräts (22) des ersten Bordnetzes (11) geschaltet ist.

3. Steuervorrichtung (16) nach einem der vorhergehenden Ansprüche, wobei die Schalteinrichtung (29) zum Unterbrechen des Stromflusses einen Transistor (T1), insbesondere einen MOSFET, aufweist.

4. Steuervorrichtung (16) nach einem der vorhergehenden Ansprüche, wobei die Schalteinrichtung (29) zum Erfassen des Spannungssignals (30) einen Steuertransistor (T2) aufweist, zwischen dessen Gate und Source das Spannungssignal (30) abfällt.

5. Steuervorrichtung (16) nach einem der vorhergehenden Ansprüche, wobei die Schalteinrichtung (29) dazu eingerichtet ist, aus zumindest einer weiteren Signalquelle (36) ein jeweiliges Schaltsignal zum von dem Potentialunterschied unabhängigen Schalten der Schalteinrichtung (29) über einen jeweiligen Steuertransistor (T2') zu empfangen.

6. Steuervorrichtung (16) nach Anspruch 5, wobei als Signalquelle (36) eine Testeinrichtung (37) zum Schalten der Schalteinrichtung (29) bei Erfüllt-Sein einer vorbestimmten, von dem Potentialunterschied unabhängigen Testbedingung vorgesehen ist.

7. Steuervorrichtung (16) nach einem der vorhergehenden Ansprüche, wobei die Schalteinrichtung (29) einen Kondensator (32) aufweist, zwischen dessen Elektroden das Spannungssignal (30) abfällt.

8. Kraftfahrzeug (10), aufweisend:
- ein erstes elektrisches Bordnetz (11), das eine erste Versorgungsspannung (U1) bereitstellt, und
- ein zweites elektrisches Bordnetz (12), das eine zweite elektrische Versorgungsspannung (U2) kleiner als die erste Versorgungsspannung (U1) bereitstellt, und
- ein Massepotential (15) für beide Bordnetze (11, 12),
**dadurch gekennzeichnet, dass**
an das erste Bordnetz (11) und das zweite Bordnetz (12) und das Massepotential (15) eine Steuervorrichtung (16) nach einem der vorhergehenden Ansprüche angeschlossen ist.

9. Verfahren zum Betreiben einer Steuervorrichtung (16) für ein Kraftfahrzeug (10), wobei die Steuervorrichtung (16) über einen ersten elektrischen Anschluss (17) eine erste Versorgungsspannung (U1) eines ersten elektrischen Bordnetzes (11) und über einen zweiten elektrischen Anschluss (18) eine zweite Versorgungsspannung (U2) eines zweiten elektrischen Bordnetzes (12) empfängt, wobei die zweite Versorgungsspannung (U2) kleiner als die erste Versorgungspannung (U1) ist, **dadurch gekennzeichnet, dass**
ein elektrischer Masseanschluss (19) zum Anschließen eines gemeinsamen Massepotentials (15) des ersten und des zweiten Bordnetzes (11, 12) bereitgestellt ist und eine dem ersten Anschluss (17) nachgeschaltete Schalteinrichtung (29) in Abhängigkeit von einem Spannungssignal (30), das von einem Potentialunterschied zwischen dem zweiten Anschluss (18) und dem Masseanschluss (19) abhängig ist, einen Stromfluss durch den ersten Anschluss (17) blockiert, um eine Rückspeisung (27) der ersten Versorgungsspannung (U1) auf das zweite elektrische Bordnetz (12) zu verhindern, falls das Spannungssignal (30) eine Unterbrechung (26) einer elektrischen Verbindung (20) zwischen dem Masseanschluss (29) und dem Massepotential (15) indiziert.

## Claims

1. Control device (16) for a motor vehicle (10), having
- a first electrical connection (17) for receiving a first supply voltage (U1) of a first voltage source (13) of a first on-board electrical system (11) of the motor vehicle (10) and
- a second electrical connection (18) for receiving a second supply voltage (U2) of a second voltage source (14) of a second on-board electrical system (12) of the motor vehicle (10), wherein the second supply voltage (U2) is smaller than the first supply voltage (U1),
wherein an electrical earth connection (19) for connecting a common earth potential (15) of the first and the second on-board systems (11, 12) is provided, wherein the earth connection (19) is provided to close a circuit both of the first on-board system (11) and of the second on-board system (12), and a switching device (29) downstream of the first connection (17) is configured to block a current flow through the first connection (17) depending on a voltage signal (30) which is a function of a potential difference between the second connection (18) and the earth connection (19), wherein the switching device (29) blocks the current flow, in order to prevent an electrical connection via an earth lead element (21) between the first electrical connection (17) and the second electrical connection (18) and a resulting return feed (27) of the first supply voltage (U1) to the second electrical on-board electrical system (12), if the voltage signal (30) indicates an interruption (26) of an electrical connection (20) between the earth connection (29) and the earth potential (15).

2. Control device (16) according to claim 1, wherein the switching device (29) is connected between the first connection (17) and a control output (23) controlled from the control device (16) to control an electrical device (22) of the first on-board system (11).

3. Control device (16) according to any one of the preceding claims, wherein the switching device (29) for interrupting the current flow has a transistor (T1), in particular a MOSFET.

4. Control device (16) according to any one of the preceding claims, wherein the switching device (29) for detecting the voltage signal (30) has a control transistor (T2), between whose gate and source the voltage signal (30) decreases.

5. Control device (16) according to any one of the preceding claims, wherein the switching device (29) is configured to receive from at least one further signal source (36) a respective switching signal for switching the switching device (29) independently of the potential difference via a respective control transistor (T2').

6. Control device (16) according to claim 5, wherein a test device (37) is provided as signal source (36) for switching the switching device (29) when a predetermined test condition, independent of the potential difference, has been fulfilled.

7. Control device (16) according to any one of the preceding claims, wherein the switching device (29) has a capacitor (32), between whose electrodes the voltage signal (30) decreases.

8. Motor vehicle (10), having:
- a first on-board electrical system (11), which provides a first supply voltage (U1), and
- a second on-board electrical system (12), which provides a second electrical supply voltage (U2) smaller than the first supply voltage (U1), and
- an earth potential (15) for both on-board systems (11, 12),
**characterised in that**
a control device (16) according to any one of the preceding claims is connected to the first on-board system (11) and the second on-board system (12) and the earth potential (15).

9. Method for operating a control device (16) for a motor vehicle (10), wherein the control device (16) receives a first supply voltage (U1) of a first on-board electrical system (11) via a first electrical connection (17) and a second supply voltage (U2) of a second on-board electrical system (12) via a second electrical connection (18), wherein the second supply voltage (U2) is smaller than the first supply voltage (U1),
**characterised in that**
an electrical earth connection (19) for connecting a common earth potential (15) of the first and the second on-board systems (11, 12) is provided and a switching device (29) downstream of the first connection (17) blocks a current flow through the first connection (17) depending on a voltage signal (30), which is a function of a potential difference between the second connection (18) and the earth connection (19), in order to prevent a return feed (27) of the first supply voltage (U1) to the second on-board electrical system (12), if the voltage signal (30) indicates an interruption (26) of an electrical connection (20) between the earth connection (29) and the earth potential (15).

## Revendications

1. Dispositif de commande (16) pour un véhicule automobile (10), présentant
- une première borne électrique (17) destinée à recevoir une première tension d'alimentation (U1) d'une première source de tension (13) d'un premier réseau de bord électrique (11) du véhicule automobile (10) et
- une seconde borne électrique (18) destinée à recevoir une seconde tension d'alimentation (U2) d'une seconde source de tension (14) d'un second réseau de bord électrique (12) du véhicule automobile (10), dans lequel la seconde tension d'alimentation (U2) est inférieure à la première tension d'alimentation (U1),
dans lequel une borne de masse électrique (19) est prévue pour connecter un potentiel de masse commun (15) des premier et second réseaux de bord (11, 12), dans lequel la borne de masse (19) est prévue aussi bien pour fermer un circuit de courant du premier réseau de bord (11) que du second réseau de bord (12), et un dispositif de commutation (29) connecté en aval de la première borne (17) est configuré en fonction d'un signal de tension (30) qui dépend d'une différence de potentiel entre la seconde borne (18) et la borne de masse (19), pour bloquer un flux de courant à travers la première borne (17), dans lequel le dispositif de commutation (29) bloque le flux de courant, pour empêcher une connexion électrique via un élément de ligne de masse (21) entre la première borne électrique (17) et la seconde borne électrique (18), et ainsi pour empêcher une récupération provoquée (27) de la première tension d'alimentation (U1) sur le second réseau de bord électrique (12), au cas où le signal de tension (30) indique une interruption (26) d'une connexion électrique (20) entre la borne de masse (29) et le potentiel de masse (15).

2. Dispositif de commande (16) selon la revendication 1, dans lequel le dispositif de commutation (29) est commuté entre la première borne (17) et une sortie de commande (23) commandée par le dispositif de commande (16) pour commander un appareil électrique (22) du premier réseau de bord (11).

3. Dispositif de commande (16) selon l'une quelconque des revendications précédentes, dans lequel le dispositif de commutation (29) présente un transistor (T1) pour interrompre le flux de courant, en particulier un MOSFET.

4. Dispositif de commande (16) selon l'une quelconque des revendications précédentes, dans lequel le dispositif de commutation (29) présente un transistor de commande (T2) pour détecter le signal de tension (30), entre la grille et la source duquel le signal de tension (30) chute.

5. Dispositif de commande (16) selon l'une quelconque des revendications précédentes, dans lequel le dispositif de commutation (29) est constitué de manière à recevoir à partir d'au moins une source de signal supplémentaire (36) un signal de commutation respectif pour commuter le dispositif de commutation (29) indépendamment de la différence de potentiel via un transistor de commande respectif (T2').

6. Dispositif de commande (16) selon la revendication 5, dans lequel un dispositif de test (37) est prévu en tant que source de signal (36) pour commuter le dispositif de commutation (29) lorsqu'une condition de test prédéterminée est satisfaite, indépendamment de la différence de potentiel.

7. Dispositif de commande (16) selon l'une quelconque des revendications précédentes, dans lequel le dispositif de commutation (29) présente un condensateur (32), entre les électrodes duquel le signal de tension (30) chute.

8. Véhicule automobile (10) présentant :
- un premier réseau de bord électrique (11), qui fournit une première tension d'alimentation (U1), et
- un second réseau de bord électrique (12), qui fournit une second tension d'alimentation électrique (U2) inférieure à la première tension d'alimentation (U1), et
- un potentiel de masse (15) pour les deux réseaux de bord (11, 12),
**caractérisé en ce que**
un dispositif de commande (16) selon l'une quelconque des revendications précédentes est connecté au premier réseau de bord (11) et au second réseau de bord (12) et au potentiel de masse (15).

9. Procédé de fonctionnement d'un dispositif de commande (16) pour un véhicule automobile (10), dans lequel le dispositif de commande (16) reçoit une première tension d'alimentation (U1) d'un premier réseau de bord électrique (11) via une première borne électrique (17) et une seconde tension d'alimentation (U2) d'un second réseau de bord électrique (12) via une seconde borne électrique (18), dans lequel la seconde tension d'alimentation (U2) est inférieure à la première tension d'alimentation (U1),
**caractérisé en ce que**
une borne de masse électrique (19) est fournie pour connecter un potentiel de masse commun (15) des premier et second réseaux de bord (11, 12) et un dispositif de commutation (29) connecté en aval de la première borne (17) en fonction d'un signal de tension (30), qui dépend d'une différence de potentiel entre la seconde borne (18) et la borne de masse (19), bloque un flux de courant à travers la première borne (17), afin d'empêcher une récupération (27) de la première tension d'alimentation (U1) sur le second réseau de bord électrique (12), au cas où le signal de tension (30) indique une interruption (26) d'une connexion électrique (20) entre la borne de masse (29) et le potentiel de masse (15).
